# EUROPEAN PATENT SPECIFICATION

(11) **EP 4 446 794 B1**
(45) Date of publication and mention of the grant of the patent: **19.11.2025**
(21) Application number: 23167506.7
(22) Date of filing: 12.04.2023
(51) Int. Cl.: G02B 26/08, B81B 7/00, B81B 3/00

(54) **TWO-AXIS MEMS MIRROR**
ZWEIACHSIGER MEMS-SPIEGEL
MIROIR MEMS À DEUX AXES

(43) Date of publication of application: 16.10.2024
(73) Proprietor: Murata Manufacturing Co., Ltd., Nagaokakyo-shi, Kyoto 617-8555 (JP)
(72) Inventor: LIUKKU, Matti, 00320 Helsinki (FI)
(74) Representative: Boco IP Oy Ab

(56) References cited:
- US-A1- 2014 340 726
- US-A1- 2019 146 211
- US-A1- 2021 223 539
- US-A1- 2023 003 996

## Description

### FIELD OF THE DISCLOSURE

The present disclosure relates to microelectromechanical (MEMS) mirror, and particularly to two-axis actuated scanning mirror.

### BACKGROUND OF THE DISCLOSURE

Two-axis microelectromechanical (MEMS) mirrors can be used in imaging devices such as light-detecting and ranging sensors (LIDARs). A MEMS mirror may contain at least one moving reflector which can reflect light beams in different directions from a laser emitter towards the surrounding environment in order to build 3D map of the scanned area. Two-axis MEMS mirrors may typically require (1) a fast rotation axis driven in resonance, and (2) a slow rotation axis that can be linearly controlled or placed into static tilted position. Additionally, MEMS mirrors may benefit from large tilting displacement to allow the beam to be directed to a wide range of angles or positions. WO2021125038A1 demonstrates a two-axis MEMS mirror with slow and fast piezoelectrically driven actuation modes. However, since piezoelectric actuators may exhibit hysteresis, their use for placing the mirror into static tilted position during quasi-static actuation mode is not easily achieved. Additionally, the loose moving structures may suffer from vertical vibrations, which is not desired in MEMS mirror.

### BRIEF DESCRIPTION OF THE DISCLOSURE

An object of the present disclosure is to provide a MEMS mirror to overcome the above problems.

The object of the disclosure is achieved by what is stated in the independent claim. The preferred embodiments of the disclosure are disclosed in the dependent claims.

The disclosure is based on the idea of two-axis MEMS mirror comprising (1) the moving parts such as frame with a reflector and piezoelectric actuators inside and support beams with moving comb fingers attached to it, and (2) the fixed parts such as static comb fingers. Further, a double-device layer allows placing the moving parts and the fixed parts in different device layers.

An advantage of such arrangement is that MEMS mirror may be effectively used with quasi-static and static mode of actuation with electrostatic actuators. Additionally, the large tilting displacement and reduced vertical vibration are achieved.

### BRIEF DESCRIPTION OF THE DRAWINGS

In the following the disclosure will be described in greater detail by means of preferred embodiments with reference to the accompanying drawings, in which
Figure 1 illustrates a cross-section of a MEMS mirror in a) non-actuated and b) electrostatically actuated states.
Figure 2a illustrates the MEMS mirror in non-actuated state.
Figures 2b-2c illustrate the MEMS mirror in actuated state: b) electrostatically actuated and c) piezoelectrically actuated.
Figure 2d illustrates the MEMS mirror with driving electrostatic actuators and sensing electrostatic actuators.
Figures 3a - 3d illustrate embodiments of the MEMS mirror with different arrangements of the anchors and anchor structures.
Figures 4a - 4c illustrate the cross-section of the MEMS mirror with different arrangements of the structure in a double-device layer.
Figure 5 illustrates an exemplary fabrication process of a MEMS mirror device.
Figure 6 illustrates an exemplary MEMS mirror device.

### DETAILED DESCRIPTION OF THE DISCLOSURE

*A MEMS mirror of this disclosure comprises a frame, which defines a first rotation axis and a second rotation axis being perpendicular to each other, and wherein the first rotation axis and the second rotation axis form four quadrants; two support beams attached to the outside of the frame and extending away from the frame along the first rotation axis; four fixing points on the inside of the frame, wherein one pair of the four fixing points are on one side of the frame, and another pair of the four fixing points are on the opposite side of the frame, and each of the four fixing points is in one of the four quadrants. The MEMS mirror also comprises a reflector with a reflective coating suspended inside the frame, and wherein the reflector comprises four connection points at its edge, and each of the four connection points is in one of the four quadrants; two suspension springs extending from the inside of the frame to the opposite sides of the reflector in the direction of the second rotation axis; four piezoelectric actuators inside the frame, wherein each piezoelectric actuator comprises a piezoelectric layer deposited on an actuation spring, and wherein each piezoelectric actuator extends from one of the four fixing points to one of the four connection points of the reflector; a double device layer, wherein the double device layer defines a horizontal plane of the mirror and a vertical direction, and wherein a vertical direction is perpendicular to the horizontal plane, and wherein the double device layer comprises a first device layer and a second device layer, and the first and the second device layers are one above the other in the vertical direction, and wherein the frame, the support beams, the reflector and the piezoelectric actuator are in the double device layer; a static support structure in the second device layer adjacent to each of the two support beams; and an electrostatic actuator at each of the two support beams, wherein each electrostatic actuator comprises a plurality of static comb fingers on the static support structure alternating with a plurality of moving comb fingers on the corresponding support beam in the first device layer.*

### Double device layer

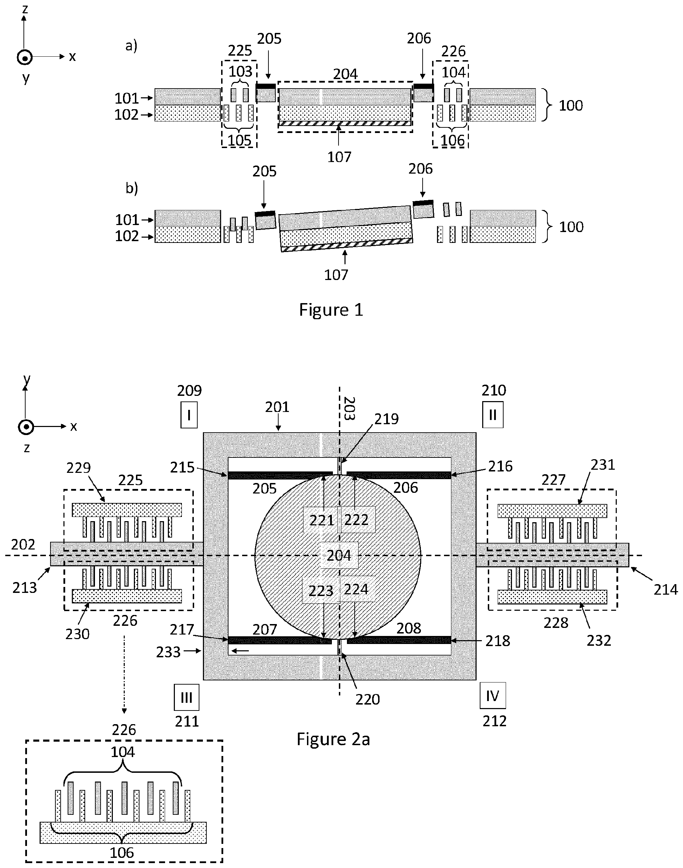

A MEMS mirror of this disclosure comprises a double device layer 100 with two superimposed layers as illustrated in Figure 1. The term double device layer signifies a structure which comprises two layers connected to each other from which the MEMS mirror is formed. The double device layer 100 defines a horizontal plane (xy-plane) of the mirror. Specifically, the static structures in the double device layer 100 may define the horizontal plane. A vertical direction is perpendicular to the horizontal plane. The vertical direction may extend along z-axis.

A first device layer 101 may be on top of a second device layer 102 in the vertical direction. A bottom surface of the first device layer 101 may be attached to a top surface of the second device layer 102. The first device layer 101 and the second device layer 102 may be attached to each other with direct bonding. Optionally, an insulating oxide layer (not illustrated) may be between the first device layer 101 and the second device layer 102. The material of the first device layer 101 and the second device layer 102 may be silicon. The first device layer 101 and the second device layer 102 may be called a first layer and a second layer correspondingly. Alternatively, if all mobile structures are in the first device layer, then the first device layer 101 and the second device layer 102 may be called a moving layer and a static layer correspondingly. However, both the first device layer 101 and the second device layer 102 may in some embodiments contain mobile structures, as figure 1 illustrates.

Words such as "horizontal", "vertical", "bottom" and "top", "above" and "below" etc. do not in this disclosure refer to the orientation of the device with regard to the direction of earth's gravitational field either when the device is manufactured or when it is in use. Instead, the word "horizontal" simply defines a plane and "vertical" defines a direction which is perpendicular to that plane. The other terms then refer to relative positions in this "vertical" direction.

### Frame

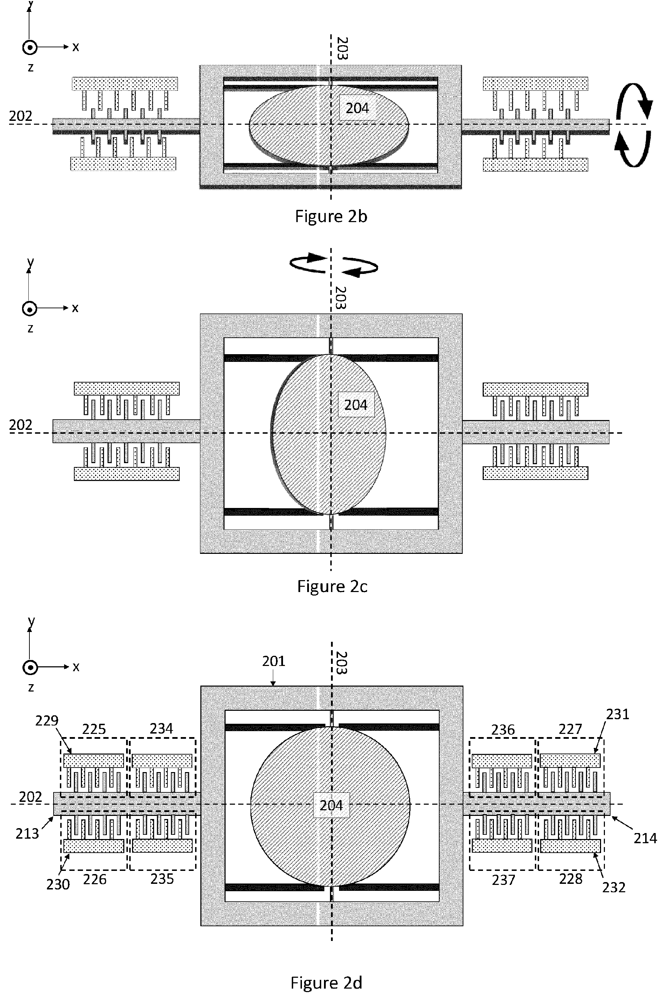

The MEMS mirror illustrated in Figure 2 comprises a frame 201 located in the double device layer 100. The frame 201 may define a frame plane of the mirror. The frame plane may be parallel to the horizontal xy-plane when the mirror is in rest position (non-actuated). The frame plane comprises a first rotation axis 202 and a second rotation axis 203. The first rotation axis 202 may be parallel to x-axis. The second rotation axis 203 may be parallel to y-axis in non-actuated state of the MEMS mirror. The frame plane may rotate around the first rotation axis 202 when the mirror is actuated.

The frame 201 may be a mechanical structure surrounding a reflector 204 and at least four piezoelectric actuators 205-208, which are introduced later in the description. The frame 201 may be attached to other parts of the MEMS mirror. The frame 201 may be movable in relation to the other fixed parts of the MEMS mirror to which it is attached. The frame may be in the first layer 101 of the mirror. The frame may be in the second layer 102 of the mirror. Alternatively, the frame may be in the first layer 101 and in the second layer 102 of the mirror. Having the frame in the first and the second device layers may provide more rigidity to the frame structure which is beneficial for the operation of the MEMS mirror.

The frame 201 may have a rectangular shape. Other shapes are also possible. A centre of the frame 201 may be defined as a point of its diagonals intersection. The area surrounded by the edges of the frame 201 may be referred to as inside of the frame 201. The area outside the edges of the frame may be referred to as the outside of the frame 201. A width 233 of the frame in the xy-plane may be greater than its thickness in the z-direction.

### Quadrants

Four quadrants 209-212 are formed by the nominal lines passed thought the centre of the frame along the first 202 and the second 203 rotation axes. A first 209 and a second 210 quadrants may be on one side of the first rotation axis 202, and a third 211 and a fourth 212 quadrants may be on another side of the first rotation axis 202. The first 209 and the third 211 quadrants may be on one side of the second rotation axis 203, and the second 210 and the fourth 212 quadrants may be on another side of the second rotation axis 203. Additionally, the first 209 and the third 211 quadrants may be on one side of the second rotation axis 203, and the second 210 and the fourth 212 quadrants may be on another side of the second rotation axis 203.

### Support beams

The MEMS mirror comprises at least two support beams 213-214, which are attached to the outside of the frame. The support beams 213-214 extend away from the frame 201 along the first rotation axis 202. The support beams 213-214 may be in the first layer 101 of the mirror. The support beams 213-214 may be in the second layer 102 of the mirror. Alternatively, the support beams 213-214 may be in the first layer 101 and in the second layer 102 of the mirror. Having the support beams in the first and the second device layers may provide more rigidity to the structure which is beneficial for the operation of the MEMS mirror.

### Fixing points

The frame 201 of the MEMS mirror further comprises at least four fixing points 215-218 at the inside. The fixing points 215-218 are the nominal places at the opposite edges of the inside of the frame 201 where the piezoelectric actuators may be attached. Each quadrant 209-212 of the frame 201 may comprise one fixing point. In other words, the frame may comprise at least two pairs of the fixing points (for example 215 and 217, 216 and 218). The pairs of the fixing points may be at the opposite edges of the frame. The fixing points of one pair may be in different quadrants of the frame. The fixing points 215-218 in each quadrant may be equidistant from the centre of the frame. The fixing points 215-218 may be positioned symmetrically at the inside of the frame 201 with respect to the first rotation axis 202 and the second rotation axis 203.

### Reflector

A reflector 204 is suspended inside the frame 201 along the frame plane. The reflector 204 may be movable in relation to the frame 201. The reflector 204 may be in the double device layer 100. Alternatively, the reflector 204 may be in the first layer 101. Alternatively, the reflector 204 may be in the second layer 102. The reflector 204 may comprise a reflective coating 107 deposited onto one of the device layers. The reflective coating 107 may be one or more metal thin film layers, such as aluminium, silver, gold or copper films. Alternatively, the coating 107 may comprise a stack of one or more dielectric films with different refractive indexes, where the films are arranged so that the stack reflects light. A thickness of the reflective coating 107 may be 100 - 1000 nm depending on the wavelength of the laser used with the MEMS mirror. For example, the thickness of the reflective coating 107 may be 500 nm. In other words, the reflector 204 may comprise at least one of the two device layers and the reflective coating attached to one of the device layers.

The reflector 204 may have rounded shape such as circle or oval. Alternatively, the reflector 204 may have square shape. The reflector 204 may be in the centre of the frame 201. In other words, the centre of the frame 201 may align with the centre of the reflector 204 in the frame plane and z direction. An outermost border of the reflector 204 may be referred to as an edge of the reflector.

At least two suspension springs 219-220 extend from the frame 201 to the reflector 204. The suspension springs 219-220 may be elongated rigid beams in the double device layer 100. The suspension springs 219-220 may be used to suspend the reflector 204 inside the frame 201. The suspension springs 219-220 may experience twisting motion when the reflector 204 rotates around the second rotation axis 203. Thus, the suspension springs may be called torsion springs. The suspension springs 219-220 may be in the first layer 101. Alternatively, the suspension springs 219-220 may be in the first device layer 101 and in the second device layer 102. The two suspension springs 219-220 may be along the second rotation axis 203. One end of each of the suspension springs 219-220 may be attached to the edge of the reflector 204 at the opposite sides. Another end of each of the suspension springs 219-220 may be attached to the inside of the frame 201. The first 219 of the suspension springs may be between the first 209 and the second 210 quadrant, and the second 220 of the suspension springs is between the third 211 and the fourth 212 quadrant.

The edge of the reflector 204 may comprise at least four connection points 221-224 to which the piezo actuators 205-208 are connected as discussed below. The edge of the reflector may comprise one connection point in each of the quadrants. The connection points 221-224 may be symmetrically positioned at the edge of the reflector 204 with respect to the first rotation axis 202 and the second rotation axis 203. The connection points 221-224 may be equidistant form the first rotation axis 202 and the second rotation axis 203.

### Actuators in MEMS mirror

In this disclosure, a term "actuator" refers to a piezoelectric or electrostatic structure which generates physical displacement (usually bending or translation) in response to a voltage applied to it or measures physical displacement. The actuator may be used to drive oscillating movement when it is controlled with a periodic AC voltage signal, or to sense the movement that another actuator has generated. The purpose of having actuators in the MEMS mirror design is to move at least some parts out of xy-plane and/or frame plane. The moving parts may include the support beams, the frame, and everything inside the frame such as the reflector, the suspension springs and the piezoelectric actuators. Two states of the MEMS mirror may be defined: non-actuated state, when the moving parts are all parallel to xy-plane and the frame plane, and actuated, when at least one of the moving parts is out of xy- or frame planes. Two types of actuators are discussed in this disclosure.

An electrostatic actuator for moving the frame with the reflector around the first rotation axis may comprise a plurality of alternating static and moving combs located in the different device layer. The moving comb fingers may be mechanically connected to the moving parts of the MEMS mirror. The distance between static and moving combs (a vertical gap) allows large translation of the moving parts around the first rotation axis. The electrostatic actuator may also be referred to as the capacitive actuator.

A bending piezoelectric actuator for moving the reflector around the second rotation axis may comprise piezoelectric layer and conductive layers, which transmit the voltage signal to the piezoelectric layers, deposited on an actuation spring. A material of the actuation spring may be an approximately 50 µm thick layer of silicon in at least one device layer, which is sufficiently thin to bend with the piezoelectric material when a voltage is applied.

### Electrostatic actuators

*The MEMS mirror wherein the elongated edges of each support beam are parallel to the second rotation axis, and the plurality of moving comb fingers is along the elongated edges of each support beam in the horizontal plane.*

The MEMS mirror comprises a static support structure in the second device layer adjacent to each of the two support beams. The MEMS mirror further comprises an electrostatic actuator at each of the two support beams, wherein each electrostatic actuator comprises a plurality of static comb fingers on the static support structure alternating with a plurality of moving comb fingers on the corresponding support beam in the first device layer. Specifically, the MEMS mirror may comprise four electrostatic actuators: one at each side of the elongated edges of the support beams (225-228 in Figure 2a). Each electrostatic actuator comprises the plurality of static comb fingers alternating with (i.e. interdigitated with) the plurality of moving comb fingers (fingers 103-106 in Figure 1, fingers 106 and 104 of actuator 226 in Figure 2a). The plurality of static comb fingers 103-104 and moving comb fingers 105-106 may extend along y-axis. At least part of the plurality of static comb fingers 103-104 are in the second device layer 102, and at least part of the plurality of moving comb fingers 105-106 are in the first 101 device layer. Specifically, the moving fingers 103-104 may be attached to the support beams 213-214. The static fingers 105-106 may be attached to at least four static support structures 229-232 in the second layer 102. The static support structures 229-232 may be parallel to the support beams 213-214 to ensure alignment of the static and moving fingers. A gap between the moving fingers 103-104 and the static fingers 105-106 in z-direction, as illustrated in Figure 1, needs to be small enough to allow presence of the fringe fields between the static and moving comb fingers before overlapping. The gap may be recessed using, for example, LOCal Oxidation of Silicon (LOCOS) process prior to fabrication of the moving and static fingers.

Each electrostatic actuator of 225-228 may be configured to move the support beams 213-214 and the frame 201 with the reflector 204 around the first rotation axis 202 as illustrated in Figure 2b. For example, when an electric field is applied between the fingers of the electrostatic actuator, the moving fingers 103-104 move with respect to the static fingers 105-106 out xy-plane either upward or downward in z-direction. Out-of-plane translating electrostatic actuators generate force in the direction of their displacement and move the moving parts of the MEMS mirror in the same direction. In other words, the electrostatic actuators 225-228 may be configured to oscillate the moving parts at a slow frequency around the first rotation axis 202. The slow frequency may, for example, be 60 Hz. The electrostatic actuators 225-228 may be electrically separated and may be independently activated.

The MEMS mirror may comprise both the driving electrostatic actuators 225-228 and the sensing electrostatic actuators 234-237 as illustrated in Figure 2d. The driving electrostatic actuators may be configured to move the moving parts in response to the applied signal. The driving electrostatic actuators may also be called the capacitive comb drives. On the opposite, the sensing electrostatic actuators may be configured to sense the position of the moving comb fingers and the moving parts. The sensing of the displacement may be based on change of the capacitance between the static and moving fingers. In other words, when the moving comb fingers move with relation to the static comb fingers, the capacitance changes with respect to the amount of displacement. The sensing may be done differentially by e.g. comparing the signal from the sensing electrostatic actuators 234 and 236 on one side from the first rotation axis 202 to the sensing electrostatic actuators 235 and 237 on the other side from the first rotation axis 202. This may help to increase the signal and eliminate common error sources. The sensing electrostatic actuators may also be called the comb sense capacitors.

### Piezoelectric actuators

At least four piezoelectric actuators 205-208 are inside the frame 201 in the double device layer 100. Each piezoelectric actuator 205-208 comprises a piezoelectric layer, such as aluminium nitride, deposited on one actuation spring to facilitate actuation movement. Each actuation spring is configured to bend out of the frame plane. Each piezoelectric actuator 205-208 extends from one of the fixing points 215-218 towards each of four quadrants 209-212 of the reflector. In other words, each piezoelectric actuator may connect one fixing point at the inside of the frame with one connection point at the edge of the reflector in one of the quadrants. All piezoelectric actuators may be connected to different fixing points and connection points.

The at least four piezoelectric actuators 205-208 may be in the first device layer 101. Alternatively, the piezoelectric actuators 205-208 may be in the first device layer 101 and the second device layer 102. However, a thickness of the piezoelectric actuator needs to be sufficiently thin to facilitate the bending movement.

The piezoelectric actuators 205-208 may be arranged in the following manner. The first 205 and a second 206 piezoelectric actuators may be aligned with each other, and a third 207 and a fourth 208 piezoelectric actuators may be aligned with each, and piezoelectric actuators 205-208 may be parallel to one of the rotation axes. Further, the piezoelectric actuators 205-208 may be parallel to the first rotation axis 202, and the piezoelectric actuators 205-208 may be equidistant from the first rotation axis 202 and perpendicular to the suspension springs 219-220 of the reflector 204.

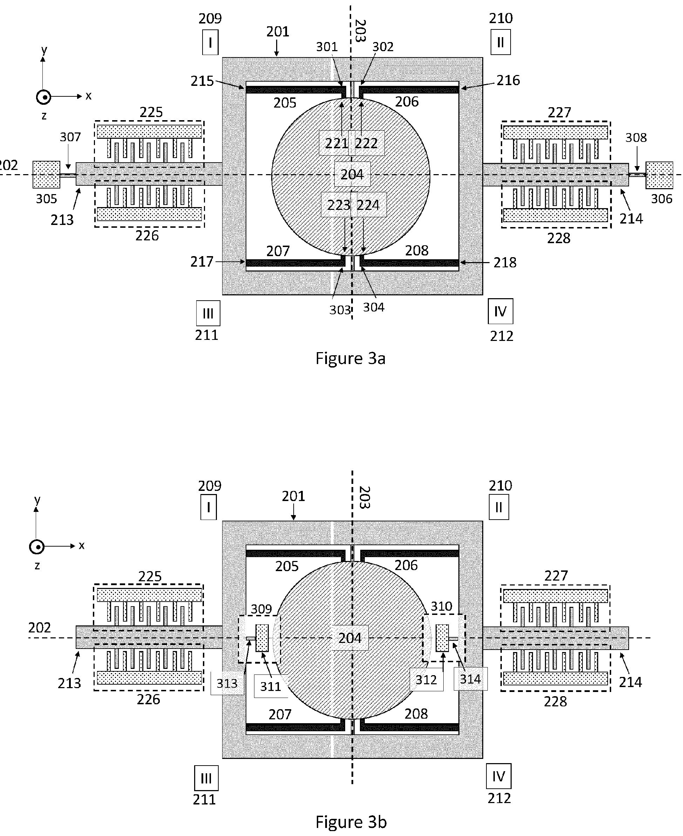

Optionally, each of the piezoelectric actuators 205-208 may comprise a flexure (for example 301-304 in Figure 3a). The flexure may be fixed to each actuation spring at one end, and to the edge of the reflector on the other end. The flexure may be orthogonal to the actuation spring. In other words, the flexure may be a connector between the actuation spring and the reflector. The flexure may be designed to twist when the actuator bends out of the frame plane. The flexure should be stiff in the vertical z-axis in order to transmit the actuation force effectively. Thus, the flexures 301-304 may be in the first device layer 101. A thickness of the flexures 301-304 may be same as the thickness of the first device layer 101.

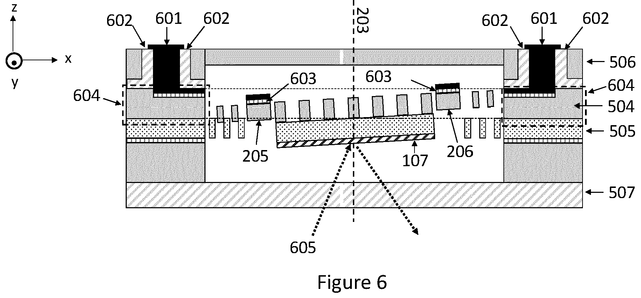

The top side of each actuation spring may be coated with the piezoelectric layer. Each actuation spring may also be coated with a metal electrode layer on two sides of the piezoelectric layer so that the actuation movement can be controlled by voltage signals in bimorph manner (bending in different directions depending on the polarity). The electrodes may, for example, be prepared from molybdenum, aluminium or titanium. The electric interconnections of the MEMS mirror device are illustrated Figure 6.

The actuation springs may further comprise sensing piezoelectric structures (not illustrated). The sensing piezoelectric structures may be configured to sense the position of the moving actuation springs and the reflector. The sensing of the displacement may be based on the voltage change produced by the bending piezoelectric layer. In other words, when the piezoelectric actuators move and bend the actuation springs and the piezoelectric layers, the sensed voltage changes with respect to the amount of displacement. The sensing piezoelectric structures may be formed from the same piezoelectric layers from which the piezoelectric actuators are formed. Alternatively, the sensing piezoelectric structures may be formed from additional sensing piezoelectric layers deposited on the actuation springs mechanically and electrically separate from the piezoelectric layers of the piezoelectric actuators.

Additionally, each actuation spring may comprise electrical contacts for actuation and sensing (not illustrated). The actuating electrical contacts may be configured to deliver electrical signals for actuation. The sensing electrical contacts may be configured to deliver electrical signals for sensing the position of the actuation spring. The actuating and sensing electrical contacts may be on different sides of each actuation spring. Alternatively, the actuating and sensing electrical contacts may be on the same side of the actuation spring. The actuating and sensing electrical contacts may be electrically separated. The sensing and actuating electrical contacts may be connected to other parts of the MEMS mirror device.

When a voltage is applied to the piezoelectric actuator, the actuation spring bends in or out of the frame plane. Out-of-plane bending piezoelectric actuators generate force in the direction of their displacement throughout their oscillating back-and-forth motion. Since each of the piezoelectric actuators 205-208 is attached to the reflector 204, the reflector 204 follows the movement of the actuators 205-208 and rotates around the second rotation axis 203 as illustrated in Figure 2c. In other words, the piezoelectric actuators 205-208 may be configured to oscillate the reflector at a fast frequency around the second rotation axis 203. The fast frequency may be, for example, 25 kHz. The fast frequency may be greater than the slow frequency of the electrostatic actuators. The piezoelectric actuators 205-208 may be electrically separated and may be independently activated.

### Modes of actuation

Two axis MEMS mirrors typically need (1) one fast axis driven in resonance and (2) slow axis that can be linearly controlled (quasi-static) and even statically placed to certain angle. Additionally, the common problem of MEMS mirrors is the movement in z-axis, so called (3) piston mode, which ideally should be minimized. All three modes of actuation are described in detail below.
(1) Resonance (fast) actuation mode:
   In this disclosure, the piezoelectric actuators are used for the resonating fast excitation to rotate the reflector around the second rotation axis as in Figure 2c. In resonance mode the frequency of excitation matches the natural frequency of the reflector resulting in the reflector oscillation with large amplitudes. The resonance frequency may be affected by the length of the suspension springs and by the length of the actuation springs of piezoelectric actuators. The main advantage of using piezoelectrical actuators is that they require low voltage for large amplitude excitation.
(2) Quasi-static (slow) actuation mode:
   In this disclosure, a vertical comb drive structure is used for slow axis (quasi-static) excitation to translate the moving parts of the MEMS mirror around the first rotation axis as in Figure 2b. In quasi-static mode, the moving parts of the MEMS mirror oscillate at low frequencies (typically below a few hundred Hertz, for example 60 Hz) and may be statically placed to a certain angle in relation to xy-plane. The static fingers and the moving fingers alternate as was discussed above. At least part of the static and moving fingers are manufactured in different device layers and have the gap in between. The advantage of this arrangement is that it allows large tilt angles and displacement of parts remote from x-axis.
   Although the static and moving fingers do not physically overlap in the absence of excitation, the electric force between them is nevertheless present due to fringe fields. However, if the gap is too large, an additional excitation may be required (for example, additional capacitive electrodes). Furthermore, more effective excitation may be achieved by designing the moving parts to be as loose as possible for reducing the required excitation force.
(3) Piston mode (z-common mode):
   The common issue that arises in MEMS mirror structures is simultaneous movement of the entire mirror in the same z-direction, or piston mode. Several reasons contribute to z-direction movement such as mechanical instability, manufacturing imperfections and thermal effects:
   - The source of mechanical instability may be the suspension and torsion springs used to hold the moving parts of the MEMS mirror in place. The springs can be unstable in z-direction and cause the moving parts to move in response to the external forces or vibrations. This can be exacerbated in two-axis MEMS mirrors, where the moving parts are configured to move around two different rotation axes.
   - Variations in the manufacturing process may result in small differences in the dimensions or material properties of the MEMS mirror and surrounding structures, which can cause Z-motion during operation.
   - Changes in temperature can cause the MEMS mirror and surrounding materials to expand or contract, which can result in motion in z-direction. This can be especially problematic if the temperature changes during operation of the MEMS mirror.

In the disclosed MEMS mirror design the piston mode movement may be minimized with suitable anchoring which may stabilize the moving parts in z-axis while preserving their dynamics around rotation axes.

### Embodiments of the MEMS mirror

All embodiments described below may be combined with each other and with all features and parts of the MEMS mirror described above, if not stated otherwise.

### (1) Embodiments with different anchor structures:

Any embodiment of this disclosure may comprise at least two anchors with torsion spring each. An anchor may be defined as a point at which any movable structure is fixed to any static structure of the MEMS mirror. The anchors may be in the second device layer 102. Alternatively, the anchors with torsion springs may be in the first device layer 101. Alternatively, the anchors may be attached to the cap wafer, which is discussed below. One function of the anchors may be to fix some areas of the moving parts, such as the frame and the support beams, and to reduce the movement in z-direction. Another function of the anchors may be routing the electrical connections between the electrical contacts of the actuators and electrical contacts in the cap wafer as discussed later.

*The MEMS mirror comprising an outer anchor point at the end of each support beam, and a torsion bar which extends from each of the outer anchor points to the nearest end of the support beam.*

In one embodiment, the MEMS mirror may comprise at least two outer anchor points 305-306 with the torsion bar 307-308 each, as illustrated in Figure 3a. Each of the anchor points may be attached to each of the support beams along the x-axis. Specifically, the anchor points may be attached to the edge of the beams furthest from the frame. In other words, the anchor points may be outside of the frame.

*The MEMS mirror further comprising an inner anchor structure inside the frame at each side from the second rotation axis, and a torsion bar extending from each of the opposite sides of the inside of the frame to each of the inner anchor structure.*

*The MEMS mirror wherein each inner anchor structure comprises an inner anchor point, and wherein a torsion bar is attached to each of the anchor points.*

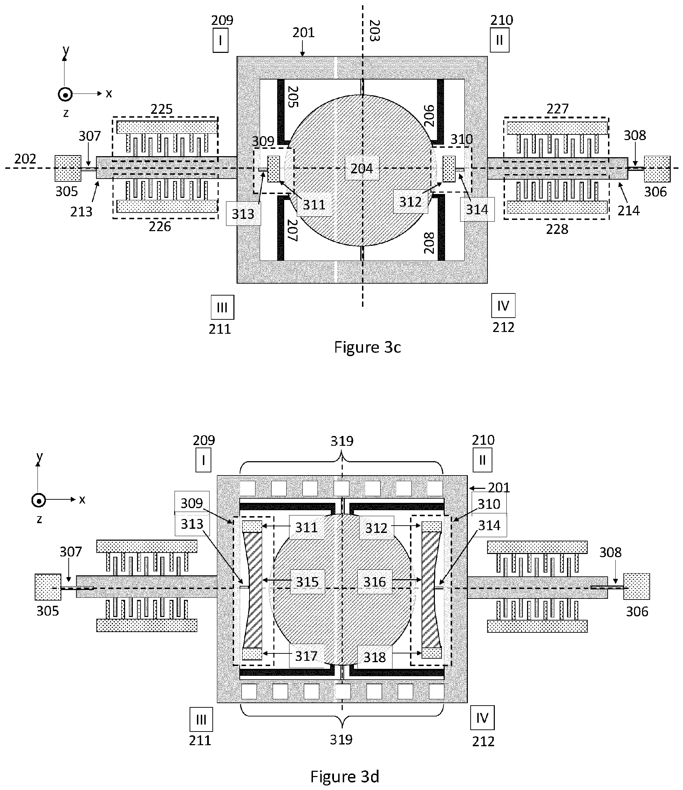

In other embodiments, the MEMS mirror may comprise at least two inner anchor structures 309-310 with the torsion bar 313-314 each inside of the frame as in Figures 3b-3d. Each torsion bar may be attached to the opposite sides of the inside of the frame. The inner anchor structure may only comprise the inner anchor point 311-312 with the torsion bar 313-314 as in Figures 3b and 3c.

*The MEMS mirror wherein each inner anchor structure comprises an anchoring beam aligned with the horizontal plane, and one anchor point at each end of the anchoring beam, and wherein a torsion bar is attached to the anchoring beam.*

Alternatively, as illustrated in Figure 3d, each inner anchor structure may comprise an anchoring beam 315-316 elongated in y-direction and aligned with xy-plane. At least two anchor points 311-312 and 317-318 may be at the opposite most remote from x-axis sides of the anchoring beam. The torsion bars 313-314 may be fixed to the anchoring beam and to the inside of the frame. The inner anchor structure may be attached to the second device layer. Alternatively, the inner anchor structure may be attached to the cap wafer (not illustrated).

The outer anchor points outside of the frame may be combined with any variation of the inner anchor structure inside the frame. All variations of anchor points and anchor structures may be used separately.

Additionally, in any embodiment of this disclosure, the torsion bars 307-308 of the outer anchor points 305-306 may be integrated into the support beams as Figure 3d demonstrates. The purpose of such modification in to reduce the size of the MEMS mirror structure.

In any embodiment of this disclosure, the piezoelectric actuators 205-208 may be parallel to the first rotation axis 202 as illustrated in Figures 2a-2d, 3a, 3b, and 3d. Alternatively, as in Figure 3c, the piezoelectric actuators 205-208 may be parallel to the second rotation axis 203.

Furthermore, in any embodiment of this disclosure, the frame structure may be perforated as in Figure 3d. In other words, the frame may have openings to lighten the frame structure while keeping it rigid and increase parasitic resonance frequencies. The openings may be along the entire frame. Alternatively, the openings may be in two opposite sides of the frame.

### (2) Embodiments with structures in different layers:

*The MEMS mirror wherein the frame is in the first device layer.*

*The MEMS mirror wherein the frame is in the first device layer and in the second device layer.*

In this disclosure, the frame of the MEMS mirror may be in the first device layer. Alternatively, the frame may be in the first and the second device layer (not illustrated in any of the Figures).

*The MEMS mirror wherein at least four piezoelectric actuators are in the first device layer.*

*The MEMS mirror wherein the reflective coating is attached to the second device layer of the reflector.*

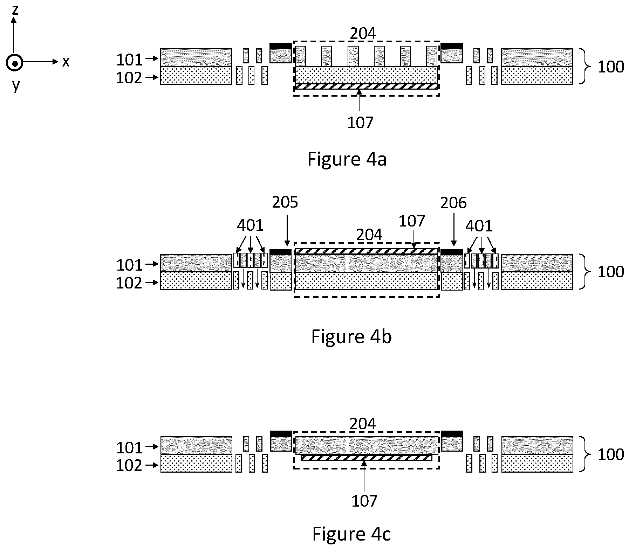

The reflective coating of the reflector may be attached to the second device layer 102, as Figure 4a illustrates. Furthermore, the piezoelectric actuators may be in the first device layer 101. Additionally, in any embodiment of this disclosure, the first layer of the reflector may be perforated if the reflector comprises both layers. The perforation of the first layer reduces the weight of the structure while preserving its rigidity.

*The MEMS mirror wherein the reflective coating is attached to the first device layer of the reflector.*

The reflective coating may be attached to the top surface of the first layer as in Figure 4b. In that case, the second layer may be attached to the first layer. The second layer may also be entirely or partly removed from the reflector. Furthermore, the piezoelectric actuators may be in the first device layer 101 and in the second device layer 102.

*The MEMS mirror wherein an additional plurality of static comb fingers is also in the first device layer.*

Further, in any embodiment of this disclosure, part of the static comb fingers 401 may be in the first device layer as in Figure 4b. Specifically, the moving comb fingers in the first device 101 layer may be configured to move while the static comb fingers 401 in the first device layer 101 may be immobile. The static comb fingers 401 in the first device layer 101 may be electrically separated from the static comb fingers in the second device layer 102. The purpose of this arrangement is to stabilize the moving parts in xy-plane when in non-actuated state by applying the voltage between the static and moving comb fingers in the first device layer 101.

The reflective coating may be alternatively attached to the bottom surface of the first layer if the second layer is removed from the reflector as in Figure 4c. The reflective coating 107 may cover the entire one side of the double device layer 100 as in Figure 1. The reflective coating 107 may cover the entire first device layer 101 as in 4a-4b. Alternatively, the reflective coating may cover part of one of the device layers as in 4c.

In all Figures 4a - 4c, the gap between the moving fingers 103-104 and the static fingers 105-106 in z-direction is illustrates A thickness of the gap may be e.g. 200 nm.

### Method of fabricating MEMS mirror device

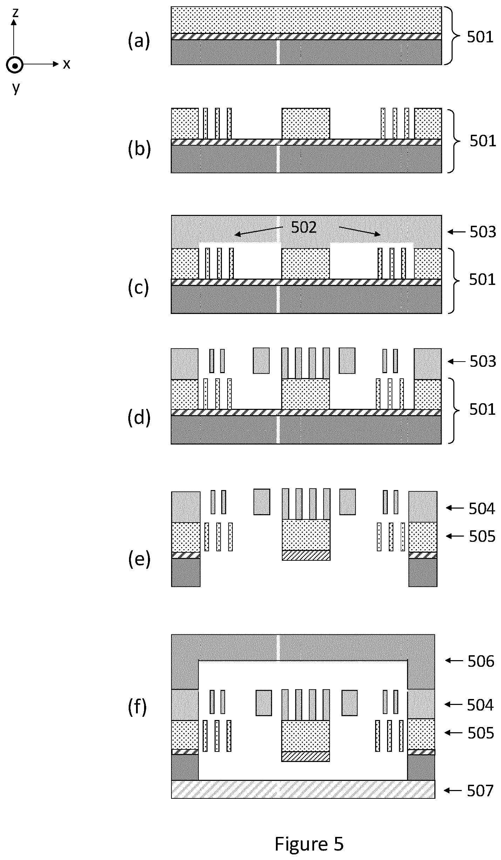

An exemplary manufacturing method of MEMS mirror device according to any of the embodiments presented above will now be described with reference to Figure 5. The manufacturing method may include the following steps:
(a) - (b): Taking silicon-on-insulator (SOI) wafer 501 and making deep silicon etching to its device layer.
(c) - (d): Making recessing to bottom of a silicon (Si) wafer with LOCal Oxidation of Silicon (LOCOS) to obtain at least four recessed areas 502, and c) attaching recessed Si wafer 503 to the initial SOI wafer 501, and d) making deep silicon etching to the Si wafer 503.

An obtained structure comprises a recessed first device layer 504 and a non-recessed second device layer 505, which may correspond to the layers 101 and 102 defined earlier in this disclosure. Optionally, an insulating oxide layer may be added between the Si wafer 503 and the SOI wafer 501 (not illustrated).
(e): Making deep silicon etching to the backside of SOI wafer 501, removing the buried oxide and patterning the reflective coating on the moving mirror.
(f): Adding a cap wafer 506 on top of the first device layer and a transparent window 507 to the bottom of the second device layer.

The material of the cap wafer 506 may be silicon. The material of the transparent window 507 may be glass.

The exemplary manufacturing method above may further comprise patterning of signal routes and contact electrodes onto the first device layer and the second device layer. Specifically, the electrical contacts may be patterned at the actuation springs of the piezoelectric actuators. Further, the electrical contacts may be patterned at the static and moving comb fingers of the electrostatic actuators. In addition, the signal routes may be patterned in the cap wafer.

### Example of the MEMS mirror device

An embodiment of a MEMS mirror device fabricated with the exemplary manufacturing process described above is illustrated in Figure 6.

The cap wafer 506 may comprise electrical contacts 601 as in Figure 6. The electrical contacts 601 may be electrically insulated with glass insulation 602. The electrical contacts 601 may be electrically connected to the electrical contacts 603 at the actuation springs of the piezoelectric actuators 205-206. The anchors defined above may be connected to a side area 604 of the first device layer 504. Thus, the electrical contacts 601 and 603 may be connected through the anchors 305-306. Optionally, if the insulating oxide layer is between the Si wafer 503 and the SOI wafer 501, the electrical connections may be routed through the oxide layer to the cap wafer 506 as the feedthrough connections (not illustrated).

Depending on the position of the reflective coating 107, position of the cap wafer 506 and the transparent window 507 may be swapped. If the reflective coating 107 is on the top surface of the first device layer, the transparent window 507 may be on top of the MEMS mirror device. Alternatively, if the reflective coating 107 is on bottom surface of the first or the second device layers, the transparent window 507 may be on the bottom of the MEMS mirror device as in Figure 6. In other words, the first device layer 504 may be closer to the cap wafer 506, and the second device layer 505 may be closer to the transparent window 507. Alternatively, the second device layer 505 may be closer to the cap wafer 506, and the first device layer 504 may be closer to the transparent window 507.

## Claims

1. A MEMS mirror comprising
- a frame, wherein the frame defines a first rotation axis and a second rotation axis being perpendicular to each other, and wherein the first rotation axis and the second rotation axis form four quadrants;
- two support beams attached to the outside of the frame and extending away from the frame along the first rotation axis;
- four fixing points on the inside of the frame, wherein one pair of the four fixing points are on one side of the frame, and another pair of the four fixing points are on the opposite side of the frame, and each of the four fixing points is in one of the four quadrants;
- a reflector with a reflective coating suspended inside the frame, and wherein the reflector comprises four connection points at its edge, and each of the four connection points is in one of the four quadrants;
- two suspension springs extending from the inside of the frame to the opposite sides of the reflector in the direction of the second rotation axis;
- four piezoelectric actuators inside the frame, wherein each piezoelectric actuator comprises a piezoelectric layer deposited on an actuation spring, and wherein each piezoelectric actuator extends from one of the four fixing points to one of the four connection points of the reflector;
**characterized in that** the MEMS mirror further comprises
- a double device layer, wherein the double device layer defines a horizontal plane of the mirror and a vertical direction, and wherein a vertical direction is perpendicular to the horizontal plane, and wherein the double device layer comprises a first device layer and a second device layer, and the first and the second device layers are one above the other in the vertical direction, and wherein the frame, the support beams, the reflector and the piezoelectric actuator are in the double device layer;
- a static support structure in the second device layer adjacent to each of the two support beams;
- and an electrostatic actuator at each of the two support beams, wherein each electrostatic actuator comprises a plurality of static comb fingers on the static support structure alternating with a plurality of moving comb fingers on the corresponding support beam in the first device layer.

2. The MEMS mirror according to claim 1, wherein the elongated edges of each support beam are parallel to the first rotation axis, and the plurality of moving comb fingers is along the elongated edges of each support beam in the horizontal plane.

3. The MEMS mirror according to any preceding claim, wherein an additional plurality of static comb fingers is also in the first device layer.

4. The MEMS mirror according to any preceding claim, comprising an outer anchor point at the end of each support beam, and a torsion bar which extends from each of the outer anchor points to the nearest end of the support beam.

5. The MEMS mirror according to any preceding claim, further comprising an inner anchor structure inside the frame at each side from the second rotation axis, and a torsion bar extending from each of the opposite sides of the inside of the frame to each of the inner anchor structure.

6. The MEMS mirror according to claim 5, wherein each inner anchor structure comprises an anchoring beam aligned with the horizontal plane, and one anchor point at each end of the anchoring beam, and wherein a torsion bar is attached to the anchoring beam.

7. The MEMS mirror according to claim 5, wherein each inner anchor structure comprises an inner anchor point, and wherein a torsion bar is attached to each of the anchor points.

8. The MEMS mirror according to any preceding claim, wherein the frame is in the first device layer.

9. The MEMS mirror according to any preceding claim, wherein the frame is in the first device layer and in the second device layer.

10. The MEMS mirror according to any preceding claim, wherein the piezoelectric actuators are in the first device layer.

11. The MEMS mirror according to any preceding claim, wherein the reflective coating is attached to the second device layer of the reflector.

12. The MEMS mirror according to any of claims 1 - 11, wherein the reflective coating is attached to the first device layer of the reflector.

## Patentansprüche

1. MEMS-Spiegel umfassend:
- einen Rahmen, wobei der Rahmen eine erste Drehachse und eine zweite Drehachse definiert, die rechtwinklig zueinander sind, und wobei die erste Drehachse und die zweite Drehachse vier Quadranten bilden;
- zwei Stützbalken, die an der Außenseite des Rahmens angebracht sind und sich entlang der ersten Drehachse vom Rahmen weg erstrecken;
- vier Befestigungspunkte an der Innenseite des Rahmens, wobei zwei der vier Befestigungspunkte auf der einen Seite des Rahmens liegen und andere zwei der vier Befestigungspunkte auf der gegenüberliegenden Seite des Rahmens liegen, und jeder der vier Befestigungspunkte in einem der vier Quadranten liegt;
- einen im Rahmen aufgehängten Reflektor mit einer spiegelnden Beschichtung, und wobei der Reflektor vier Verbindungspunkte an seinem Rand umfasst, und jeder der vier Verbindungspunkte in einem der vier Quadranten liegt;
- zwei Aufhängungsfedern, die sich von der Innenseite des Rahmens zu den gegenüberliegenden Seiten des Reflektors in der Richtung der zweiten Drehachse erstrecken;
- vier piezoelektrische Aktoren innerhalb des Rahmens, wobei jeder piezoelektrische Aktor eine auf einer Betätigungsfeder aufgebrachte piezoelektrische Schicht umfasst, und wobei jeder piezoelektrischer Aktor sich von einem der vier Befestigungspunkte zu einem der vier Verbindungspunkte des Reflektors erstreckt;
**gekennzeichnet dadurch, dass** der MEMS-Spiegel ferner umfasst:
- eine doppelte Bauelementschicht, wobei die doppelte Bauelementschicht eine horizontale Ebene des Spiegels und eine vertikale Richtung definiert, und wobei eine vertikale Richtung senkrecht zur horizontalen Ebene ist, und wobei die doppelte Bauelementschicht eine erste Bauelementschicht und eine zweite Bauelementschicht umfasst, und die erste und die zweite Bauelementschicht in der vertikalen Richtung übereinander liegen, und wobei der Rahmen, die Stützbalken, der Reflektor und der piezoelektrische Aktor in der doppelten Bauelementschicht liegen;
- eine statische Stützstruktur in der zweiten Bauelementschicht angrenzend zu jedem der beiden Stützbalken;
- und einen elektrostatischen Aktor an jedem der beiden Stützbalken, wobei jeder elektrostatische Aktor eine Mehrzahl von statischen Kammfingern an der statischen Stützstruktur abwechselnd mit einer Mehrzahl von beweglichen Kammfingern am entsprechenden Stützbalken in der ersten Bauelementschicht umfasst.

2. MEMS-Spiegel nach Anspruch 1, wobei die länglichen Kanten jedes Stützbalkens parallel zur ersten Drehachse sind und die Mehrzahl von beweglichen Kammfingern entlang der länglichen Kanten jedes Stützbalkens in der horizontalen Ebene liegt.

3. MEMS-Spiegel nach einem vorhergehenden Anspruch, wobei es auch eine weitere Mehrzahl von statischen Kammfingern in der ersten Bauelementschicht gibt.

4. MEMS-Spiegel nach einem vorhergehenden Anspruch, umfassend einen äußeren Ankerpunkt am Ende jedes Stützbalkens und einen Torsionsstab, der sich von jedem der äußeren Ankerpunkte bis zum nächstgelegenen Ende des Stützbalkens erstreckt.

5. MEMS-Spiegel nach einem vorhergehenden Anspruch, ferner umfassend eine innere Ankerstruktur innerhalb des Rahmens auf jeder Seite zur zweiten Drehachse und einen Torsionsstab, der sich von jeder der gegenüberliegenden Seiten der Innenseite des Rahmens bis zur jeweiligen inneren Ankerstruktur erstreckt.

6. MEMS-Spiegel nach Anspruch 5, wobei jede innere Ankerstruktur einen mit der horizontalen Ebene gefluchteten Ankerbalken und einen Ankerpunkt an jedem Ende des Ankerbalkens umfasst, und wobei ein Torsionsstab am Ankerbalken angebracht ist.

7. MEMS-Spiegel nach Anspruch 5, wobei jede innere Ankerstruktur einen inneren Ankerpunkt umfasst, und wobei ein Torsionsstab an jedem der Ankerpunkte angebracht ist.

8. MEMS-Spiegel nach einem vorhergehenden Anspruch, wobei der Rahmen in der ersten Bauelementschicht liegt.

9. MEMS-Spiegel nach einem vorhergehenden Anspruch, wobei der Rahmen in der ersten Bauelementschicht und in der zweiten Bauelementschicht liegt.

10. MEMS-Spiegel nach einem vorhergehenden Anspruch, wobei die piezoelektrischen Aktoren in der ersten Bauelementschicht liegen.

11. MEMS-Spiegel nach einem vorhergehenden Anspruch, wobei die spiegelnde Beschichtung an der zweiten Bauelementschicht des Reflektors angebracht ist.

12. MEMS-Spiegel nach einem der Ansprüche 1 bis 11, wobei die spiegelnde Beschichtung an der ersten Bauelementschicht des Reflektors angebracht ist.

## Revendications

1. Miroir MEMS comprenant
- un cadre, ledit cadre définissant un premier axe de rotation et un deuxième axe de rotation perpendiculaires entre eux, et ledit premier axe de rotation et ledit deuxième axe de rotation formant quatre quadrants ;
- deux poutres de support attachées à l'extérieur du cadre et s'éloignant du cadre le long du premier axe de rotation ;
- quatre points de fixation sur l'intérieur du cadre, une paire des quatre points de fixation étant située sur un côté du cadre et une autre paire des quatre points de fixation étant située sur le côté opposé du cadre, et chacun des quatre points de fixation étant situé dans l'un des quatre quadrants ;
- un réflecteur avec un revêtement réfléchissant suspendu à l'intérieur du cadre, et ledit réflecteur comprenant quatre points de liaison sur son bord, et chacun des quatre points de liaison étant situé dans l'un des quatre quadrants ;
- deux ressorts de suspension s'étendant de l'intérieur du cadre vers les côtes opposés du réflecteur dans la direction du deuxième axe de rotation ;
- quatre actionneurs piézoélectriques à l'intérieur du cadre, chaque actionneur piézoélectrique comprenant une couche piézoélectrique déposée sur un ressort d'actionnement, et chaque actionneur piézoélectrique s'étendant de l'un des quatre points de fixation vers l'un des quatre points de liaison du réflecteur ;
**caractérisé en ce que** le miroir MEMS comprend également
- une double couche de dispositif, ladite double couche de dispositif définissant un plan horizontal du miroir et une direction verticale, et une direction verticale étant perpendiculaire au plan horizontal, et la double couche de dispositif comprenant une première couche de dispositif et une deuxième couche de dispositif, et les première et deuxième couches de dispositif étant superposées dans la direction verticale, et le cadre, les poutres de support, le réflecteur et l'actionneur piézoélectrique étant situés dans la double couche de dispositif ;
- une structure de support statique dans la deuxième couche de dispositif adjacente à chacune des deux poutres de support ;
- et un actionneur électrostatique à chacune des deux poutres de support, chaque actionneur électrostatique comprenant une pluralité de dents de peigne statiques sur la structure de support statique en alternance avec une pluralité de dents de peigne mobiles sur la poutre de support correspondante dans la première couche de dispositif.

2. Miroir MEMS selon la revendication 1, dans lequel les bords allongés de chaque poutre de support sont parallèles au premier axe de rotation et la pluralité de dents de peigne mobiles est située le long des bords allongés de chaque poutre de support dans le plan horizontal.

3. Miroir MEMS selon une revendication précédente quelconque, dans lequel une pluralité supplémentaire de dents de peigne statiques est également située dans la première couche de dispositif.

4. Miroir MEMS selon une revendication précédente quelconque, comprenant un point d'ancrage extérieur à l'extrémité de chaque poutre de support et une barre de torsion qui s'étend de chacun des points d'ancrage extérieurs jusqu'à l'extrémité la plus proche de la poutre de support.

5. Miroir MEMS selon une revendication précédente quelconque, comprenant également une structure d'ancrage intérieure à l'intérieur du cadre sur chaque côté du deuxième axe de rotation et une barre de torsion s'étendant de chacun des côtés opposés de l'intérieur du cadre jusqu'à chacune des structures d'ancrage intérieures.

6. Miroir MEMS selon la revendication 5, dans lequel chaque structure d'ancrage intérieure comprend une poutre d'ancrage alignée sur le plan horizontal et un point d'ancrage à chaque extrémité de la poutre d'ancrage, et dans lequel une barre de torsion est attachée à la poutre d'ancrage.

7. Miroir MEMS selon la revendication 5, dans lequel chaque structure d'ancrage intérieure comprend un point d'ancrage intérieur, et dans lequel une barre de torsion est attachée à chacun des points d'ancrage.

8. Miroir MEMS selon une revendication précédente quelconque, dans lequel le cadre est situé dans la première couche de dispositif.

9. Miroir MEMS selon une revendication précédente quelconque, dans lequel le cadre est situé dans la première couche de dispositif et dans la deuxième couche de dispositif.

10. Miroir MEMS selon une revendication précédente quelconque, dans lequel les actionneurs piézoélectriques sont situés dans la première couche de dispositif.

11. Miroir MEMS selon une revendication précédente quelconque, dans lequel le revêtement réfléchissant est attaché à la deuxième couche de dispositif du réflecteur.

12. Miroir MEMS selon l'une des revendications 1 à 11, dans lequel le revêtement réfléchissant est attaché à la première couche de dispositif du réflecteur.
